# EUROPEAN PATENT APPLICATION

(11) **EP 4 610 871 A1**
(43) Date of publication of application: **03.09.2025**
(21) Application number: 24160464.4
(22) Date of filing: 29.02.2024
(51) Int. Cl.: G06F 30/15, G06F 30/17, B64C 3/14, B64C 3/38

(54) **A METHOD FOR GENERATING AND MANUFACTURING A BIONIC AIRFOIL**

(71) Applicant: Airbus Operations GmbH, 21129 Hamburg (DE)
(72) Inventor: Zecheru, Mihai, 21129 Hamburg (DE)

(57) **Abstract**

In order to generate a bionic derived airfoil (50) from a conventional template airfoil (10), the invention proposes marking a plurality of upper support points (22) and lower support points (24) that are arranged on an upper template surface (12) and on the lower template surface (14) of the template airfoil (10), respectively. A plurality of connecting line segments (44, 84) is constructed between the upper support points (22) and the lower support points (24) in a manner that none of the connecting line segments (44, 84) intersect with each other. The resulting zig-zag pattern can be used as an aerodynamic surface of the bionic derived airfoil (50) or as a basis for a construction line (54) from which the bionic derived airfoil (50) is further generated. The resulting airfoil manufacturing data are given to an appropriate manufacturing facility for manufacture of the bionic derived airfoil (50).

## Description

The invention relates a computer-implemented method for generating airfoil manufacturing data, specifically for a bionic airfoil, from template data. The invention further relates to a an airfoil for an adaptable wing, where the airfoil has a bionic surface. The invention further relates to an adaptable airfoil for a wing.

The integration of bionic features into engineered mechanical components, often referred to as biomimicry or bio-inspired engineering, typically involves the adaptation of principles and designs from biology to solve complex engineering problems. This approach is grounded in the understanding that natural systems have evolved over millions of years to become highly efficient and sustainable. By mimicking these natural designs and processes, engineers can create innovative and more efficient mechanical components.

One example for a remarkable design are the wings of dragonflies. As in aeronautics, the goal is to generate lift by means of an airflow along a chordwise direction. While conventional airfoil designs for aerial vehicles show great performance in their respective flow regimes (typically characterized by the Reynolds number Re), there is a desire for airfoil shapes that show great performance in a regime of small Reynolds numbers, e.g., in low density or small velocity conditions.

An (admittedly extreme) example for low Reynolds regimes to operate in is the martian atmosphere, where the Mars helicopter Ingenuity has successfully completed more than 70 starts and landings using rather conventional airfoil design.

Aerodynamic performance of an airfoil is typically measured by the quotient of lift to drag (CI/Cd) generated by the airfoil, i.e., how much more lift is generated by the airfoil compared to its drag.

It is the object of the invention to improve airfoils and their manufacturing. The object is achieved by the subject-matter of the independent claims. Preferred embodiments are subject-matter of the dependent claims.

The invention provides a computer-implemented method for generating airfoil manufacturing data from template data, wherein the airfoil manufacturing data are configured to cause manufacturing of a derived airfoil, wherein the template data describe a template airfoil, the method comprising:
a) marking a plurality of support points, namely at least upper support points and lower support points, wherein the upper support points are arranged on an upper template surface of the template airfoil and the lower support points are arranged on the lower template surface of the template airfoil;
b) constructing a plurality of connecting line segments between the upper support points and the lower support points in a manner that none of the connecting line segments intersect with each other;
c) generating the airfoil manufacturing data based on the results of step b).

The method allows taking in a conventional airfoil as a template. Multiple support points can be marked on the contour of the airfoil, i.e., the upper and lower surface. The marking can be done manually or automatically. After marking the support points, said points are connected with straight line segments. These segments represent the new surface of the airfoil. The airfoil manufacturing data can be generated in the form of CAD/CAM data such that the airfoil can be manufactured. In other words, although not explicitly mentioned, this step may involve certain sanity checks and manipulation of the data such that manufacturing can be done. The resulting airfoil comprises at least one surface that has features similar to a dragonfly wing.

With the proposed method it is comparatively simple to generate airfoils inspired from nature. Taking into accunt that in the insect world there are examples suitable for flying at low Reynolds speeds in a very efficient manner, the ideas presented herein are aimed to utilize the advantages for general aviation or defence. In contrast to just disclosing the geometry, a practical way to derive so called "dragonized" airfoils from classical/conventional airfoils is presented. The derived airfoils allow for more aerodynamic performance and/or mechanical stability of the lifting surfaces.

Preferably, step a) involves marking the support points including a leading edge support point, that is arranged where the upper template surface and the lower template surface meet at the leading edge location. Preferably, step b) involves constructing a leading edge line segment that connects the leading edge support point with the most forward upper support point or lower support point. With the leading edge being included in the process, the incident flow may be adapted to the newly formed surface.

Preferably, step a) involves marking the support points including a trailing edge support point, that is arranged where the upper template surface and the lower template surface meet at the trailing edge location. Preferably, step b) involves constructing a trailing edge line segment that connects the trailing edge support point with the most aftward upper support point or lower support point. With the trailing edge being included in the process the outgoing flow may be adapted to the newly formed surface.

Preferably, step a) involves marking the upper support points and the lower support points to be distributed along the chordwise direction such that connecting line segments that meet at a particular support point form an acute angle or and obtuse angle. With this distribution recessed and protruding undulations may be formed that are able to generate a vortex flow within them. The vortex flow may act as an energy storage for the airflow that can improve low Reynolds regime behavior.

Preferably, step a) involves marking the support points including at least one mid support point, each mid support point being arranged on one connecting line segment, preferably in the middle of the connecting line segment. Preferably, step c) involves modifying the connecting line segments to meet at every other mid support point along the chordwise direction and outputting the modified connecting line segments as the airfoil manufacturing data. With this configuration, the airfoil may be designed with a forward or backward oriented undulation structure that allows improvement in the low Reynolds regime.

Preferably, step a) involves marking the support points to be distributed along the chordwise and the spanwise direction of the template airfoil. Preferably, wherein step b) involves constructing the connecting line segments also along the spanwise direction to form a zig-zag pattern, when viewed along the spanwise direction. With this process, the airfoil is considered in its three-dimensional configuration. In other words, instead of only changing the profile, the undulation pattern can be generated also varying along the spanwise direction.

Preferably, step c) involves defining a construction line that is composed of the connecting line segments; and generating derived airfoil surface data, that describe a derived airfoil surface of the derived airfoil, by generating surface line segments that are parallel to the construction line and have a distance from the construction line from 1 % to 5 % of the chord length, and outputting the surface line segments as airfoil manufacturing data. With this process, instead of generating a new "dragonized" surface of the airfoil, the whole body can be redesigned.

Preferably, step c) involves: for at least one support point, removing an end portion of the connecting line segments meeting at the respective support point and adding a fillet portion that connects the remaining connecting line segments to obtain a construction line, and outputting the construction line as airfoil manufacturing data, wherein preferably the fillet radius of the fillet portion is 1 % to 10 % of the chord length. Preferably, step c) involves defining the construction line to include the fillet portion, and generating the derived airfoil surface data by generating a surface fillet portion that follows the contour of the construction line, and outputting the surface fillet portion as airfoil manufacturing data. Fillet portions allow for a smoother transition between portions. It is also possible that the fillet portions may act as solid hinges such that the airfoil is allowed to flex and self-adapt to different aerodynamic conditions.

Preferably, step c) involves generating upper derived airfoil surface data, that describe an upper derived airfoil surface, and generating lower derived airfoil surface data, that describe a lower derived airfoil surface, by setting an upper fillet radius of an upper fillet portion of the upper derived airfoil surface to be greater than a lower fillet radius of a lower fillet portion of the lower derived airfoil surface, and outputting the upper and lower derived airfoil surface data as the airfoil manufacturing data. The process can be performed in a targeted manner on the upper airfoil surface, the lower airfoil surface or both.

Preferably, step c) involves generating the airfoil manufacturing data to describe a closed body. With this, the airfoil manufacturing data can be completed to be manufacturable with different methods. In particular it is possible to use the data directly for manufacturing by 3d printing techniques and other additive methods.

The invention provides a manufacturing method for manufacturing a derived airfoil, the method comprising carrying out a previously described method to obtain airfoil manufacturing data; and manufacturing the derived airfoil according to the airfoil manufacturing data.

The invention provides an airfoil for an aircraft, preferably a remotely piloted aerial vehicle, wherein the airfoil is obtainable by the previously described manufacturing method.

The invention provides an aircraft, preferably a remotely piloted aerial vehicle, comprising an airfoil obtainable by the manufacturing method.

The invention provides a manufacturing facility comprising means for carrying out the manufacturing method.

The invention provides a computer program comprising instructions that, upon execution by a computer, cause the computer to carry out a previously described method.

The invention provides a computer program comprising instructions that, upon execution by a manufacturing facility, cause the manufacturing facility to carry out the manufacturing method.

The invention provides a computer-readable storage medium comprising the computer program.

The invention provides an airfoil for a wing of an aerial vehicle or a ground-effect vehicle, preferably for a remotely piloted vehicle, the airfoil comprising a leading edge portion and a trailing edge portion that are spaced apart along a chordwise direction; and a main portion that is arranged between the leading edge portion and the trailing edge portion, wherein the main portion includes a conventional surface portion and a bionic surface portion, wherein the conventional surface portion is formed as a conventional airfoil surface, wherein the bionic surface portion is formed with a plurality of undulations along a thickness direction, wherein the conventional surface portion and the bionic surface portion are formed on opposite sides of the airfoil along the thickness direction.

The undulations allow generation of a vortex flow within a recessed undulation. The vortex may serve as an energy storage for the incident airflow. With this configuration, even at low Reynolds numbers, the aerodynamic performance is large enough to reduce the risk of stalling.

Preferably, the conventional surface portion forms an upper airfoil surface and the bionic surface portion forms a lower airfoil surface; or the conventional surface portion forms a lower airfoil surface and the bionic surface portion forms a lower airfoil surface. "Dragonizing" one surface of the airfoil, i.e., having only one derived bionic surface can be sufficient to significantly enhance the aerodynamic performance.

Preferably, each undulation comprises a first straight surface portion and a second straight surface portion that meet at a cusp portion. Preferably, the cusp portion comprises a fillet portion. A roughly triangular cross-section of the undulation is a simple configuration that nevertheless allows for sufficient vortex formation. A fillet can help with inflow into and outlow out of the undulation.

Preferably, the undulations are formed either as a protruding undulation that protrudes away from the conventional surface portion along the thickness direction or as a recessed undulation that is recessed towards the conventional surface portion along the thickness direction. Protruding undulations typically extend not more than the boundary of a conventional airfoil and can define a chicane for the airflow to encourage vortex formation. Recessed undulations typically are recessed relative to the outermost contour of a conventional airfoil and offer space for vortex formation.

The invention provides a wing for an aircraft, the wing comprising a first airfoil and a second airfoil that are configured as previously described, and a mechanism that is configured to move the first and second airfoils relative to each other along the thickness direction. The airfoils of the wing can be moved by the mechanism to adapt to different flight conditions. By tendency, the closer the airfoils are together, the better the aerodynamic performance for larger speeds and vice versa. In other words, for lower Reynolds numbers, the airfoils should be moved more apart to obtain the desired aerodynamic performance. Ideally, this wing allows perching, where the landing speed is essentially zero and the angle of attack is comparatively large.

Preferably, the mechanism is configured to move the first and second airfoils into a closed position, in which the first and second airfoils collectively form a conventional airfoil. With this configuration, the wing can be transitioned between a conventional wing, e.g., for larger Reynolds numbers, and a configuration that allows better aerodynamic performance for smaller Reynolds numbers.

Preferably, the undulations of the first and second airfoil are matched such that a protruding undulation is able to protrude into a recessed undulation, if a distance between the first and second airfoil falls below a predetermined threshold. Preferably, the undulations are matched such that the first and second airfoil contact each other in the closed position. With this configuration, the wing can be completely closed to form an aerodynamically smooth conventional wing.

Preferably, the first and second airfoils are arranged such that the respecitve bionic surface portions face each other. Preferably, the mechanism is configured to move the first and second airfoils into an open position, in which the first and second airfoils define a flow passage therebetween. Preferably, the undulations form a boundary, preferably an upper and a lower boundary, of the flow passage. With this configuration, the bionic surfaces form chichanes for the airflow that allow vortex formation. Each vortex may serve as a small energy storage that improves aerodynamic performance at low Reynolds numbers.

The invention provides an aerial vehicle or a ground-effect vehicle, preferably for a remotely piloted vehicle, wherein the vehicle comprises a previously described airfoil and/or a previously described wing.

The invention provides an airfoil configured for a fixed wing or a rotary wing of an aerial vehicle or a ground-effect vehicle, preferably for a remotely piloted vehicle, the airfoil comprising a plurality of straight portions that form a plurality of undulating portions that undulate along a thickness direction, when viewed along a spanwise direction. The undulating portions allow the incident airflow to generate vortices. The vortices serve as a storage for energy and enable higher aerodynamic performance in a low speed Reynolds regime.

Preferably, at least one undulating portion comprises a first straight portion, a second straight portion and a fillet portion, wherein the fillet portion connects the first straight portion to the second straight portion. A fillet portion allows a smoother transition of airflow between adjacent undulations.

Preferably, at least one undulating portion comprises a hinge portion that is arranged between two adjacent straight portions, wherein the hinge portion is configured to allow a bending movement of the adjacent straight portions relative to each other. With this configuration a self-adapting wing is possible. The hinges allow a change in chord length and/or camber.

Prefeably, at least one hinge portion is enfeebled such that upon exceeding a predetermined buckling force, the two adjacent straight portions bend towards or away from each other. With this configuration, instead of a continuous adaption, it is possible to include a threshold behavior that allows a change in chord length and/or camber, when the airflow exceeds a certain Reynolds number.

Prefarbly, at least one undulating portion comprises an actuator that is configured to cause a bending motion of two adjacent straight portions relative to each other. Preferably, at least one actuator is configured to cause the bending motion such that any of an airfoil chord length and an airfoil camber is modified, preferably increased or decreased. With this configuration it is possible to actively adapt the airfoil, e.g., the chord length or the camber.

Preferably, at least one actuator is configured to cause the bending motion such that any of the airfoil chord length and the airfoil camber varies continuously along the spanwise direction. With this configuration, the aerodynamic parameters of the airfoil can be changed in three dimensions to allow improved adaption.

Preferably, the airfoil further comprises a leading edge portion that is formed with a rounded nose portion. Preferably, the nose portion has a greater thickness as the other portions of the airfoil. Preferably, a leading edge actuator is arranged to allow a downward movement of the nose portion. With this configuration, the novel airfoil is able to perform similar actions as a droop nose.

Preferably, at least one undulating portion has formed therein a fluid passage that is configured to allow airflow from a lower airfoil side to an upper airfoil side and blocks airflow in the opposite direction. Preferably, the fluid passage is covered with a leaf-like member that is configured to vibrate. Preferably, the leaf-like member is vibrated by a piezo actuator or configured as a piezo actuator. As the undulations allow forming of vortices, said vortices also interact with the airflow over the airfoil. This interaction may transfer momentum on an area similar to the boundary layer or even the boundary layer itself. The vortices may be energized by by mechanical the mechanical means which allows an increase in the momentum transfer on the boundary layer. As a result stall conditions can be delayed and potentially lift can be increased.

Preferably, at least one undulating portion comprises a rotor that is configured to rotate such that a vortex formed in the undulating portion is strengthened or weakened. Similarly, rotors can be used to energize or deenergize the vortices forming in the undulations, thereby allowing an adaption of the airfoil to different regimes of Reynolds numbers.

The invention provides a fixed wing or a rotary wing for an aerial vehicle or a ground-effect vehicle, preferably for a remotely piloted vehicle, wherein the wing comprises a previously described airfoil.

The invention provides an aerial vehicle or a ground-effect vehicle, preferably for a remotely piloted vehicle, wherein the vehicle comprsies a previously described airfoil or a previously described wing.

An idea is to propose a practical way to generate derived ("dragonized") airfoils from conventional airfoils. The derived airfoils are generally inspired by wings of flying insects. Some wind tunnel simulations and experiments were conducted to estimate the viability of the idea. A comparison of the aerodynamic performance between conventional airfoils and the derived airfoils based on the simulations and experiments demonstrates that for Reynolds numbers up to 200,000 nearly all derived airfoils show a significant improvement in the aerodynamic performance (CI/Cd).

Embodiments of the invention are described in more detail with reference to the accompanying schematic drawings that are listed below
- Fig. 1A to Fig. 1F: depicts an embodiment of a method for generating airfoil manufacturing data;
- Fig. 2A and Fig. 2B: depict an embodiment of a derived airfoil;
- Fig. 3A to Fig. 3D: depicts a variant of the method of Fig. 1;
- Fig. 4: depicts a variant of the method of Fig. 1;
- Fig. 5: depicts a result of the method of Fig. 4;
- Fig. 6A to Fig. 6C: depicts an embodiment of an adaptable wing;
- Fig. 7: depicts a diagram of lift coefficient (CI) v. angle of attack (AoA) of the wing of Fig. 6;
- Fig. 8A to Fig. 8C: depict an embodiment of an adaptable airfoil;
- Fig. 9: depicts a variant of an adaptable airfoil;
- Fig. 10A and Fig. 10B: depict a variant of an adaptable airfoil;
- Fig. 11A and Fig. 11B: depict an embodiment of an adaptable wing;
- Fig. 12A and Fig. 12B: depict an embedment of an airfoil with active flow control; and
- Fig. 13A and Fig. 13B: depict a variant of an airfoil with flow control.

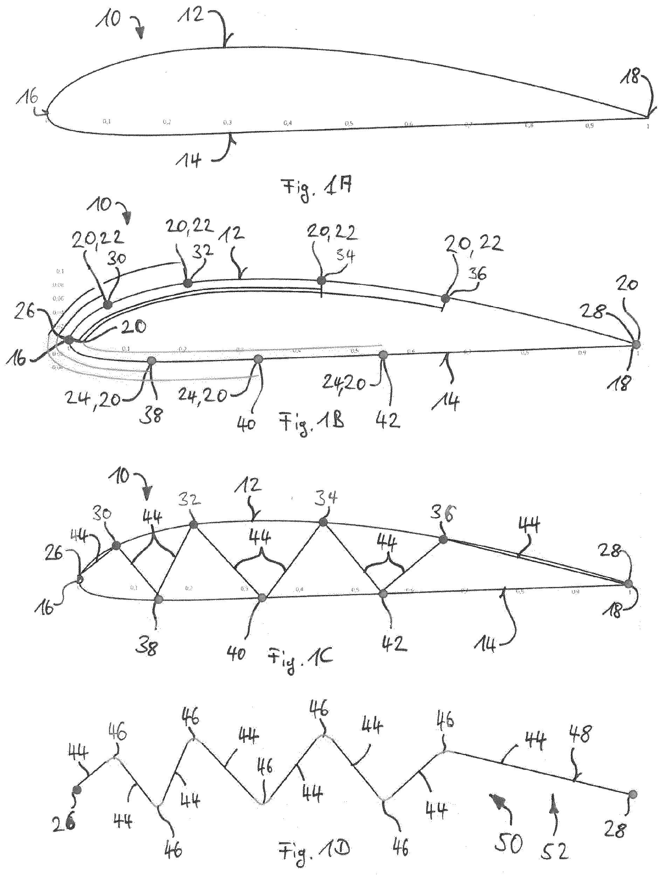

Referring to Fig. 1A to Fig. 1G, a method for generating airfoil manufacturing data is described in more detail. A template airfoil 10 is given, e.g., a Clark Y airfoil. Other template airfoils 10 are possible and are selected from a group of conventional airfoils.

The template airfoil 10 has an upper template surface 12 and a lower template surface 14. The upper and lower template surfaces 12, 14 meet at the template leading edge 16 and the template trailing edge 18, respectively. The direction along the template leading and trailing edges 16, 18 is the chordwise direction in the usual manner. The direction in the drawing plane that is perpendicular to the chordwise direction is called the thickness direction, and the direction perpendicular to both the chordwise and thickness direction is the spanwise direction.

Referring to Fig. 1B, a plurality of support points 20 are marked on the template airfoil 10, e.g., four upper support points 22 and three lower support points 24. In addition a leading edge support point 26 and a trailing edge support point 28 are marked. The leading and trailing edge support points 26, 28 are marked at 0 % and 100 % chord length, respectively. The remaining upper and lower support points 22, 24 are preferably measured along the contour length of the upper and lower template surfaces 12, 14 and not along the chord.

A first to a fourth upper support point 30, 32, 34, 36 are marked at 10 % to 15 %, 25 % to 30 %, 42 % to 48 %, and 60 % to 70 % of the upper contour length, respectively.

A first to a third lower support point 38, 40, 42 are marked at 15 % to 22 %, 33 % to 40 %, and 53 % to 60 % of the lower contour length, respectively.

Referring to Fig. 1C, multiple connecting line segments 44 are constructed. The connecting line segments 44 are constructed without intersections. In particular, the leading edge support point 26 is connected to the first upper support point 30. The subsequent second to forth upper support points 32, 34, 36 and the first to third lower support points 38, 40, 42 are connected in an alternating manner thereby forming a zig-zag pattern. The third lower support point 42 is connected to the trailing edge support point 28.

Referring to Fig. 1D, a region around those support points 20, where two connecting line segments 44 meet is replaced with a fillet portion 46. The radius of the fillet portion 46 is adapted to the application and is typically on the order of about 2 % of the chord length. Thus a derived airfoil surface 48 can be generated. The derived airfoil surface 48 is included in existing airfoil manufacturing data by replacing at least one of the upper and lower template surface 12, 14 thereby generating airfoil manufacturing data that allow manufacture of a derived airfoil 50.

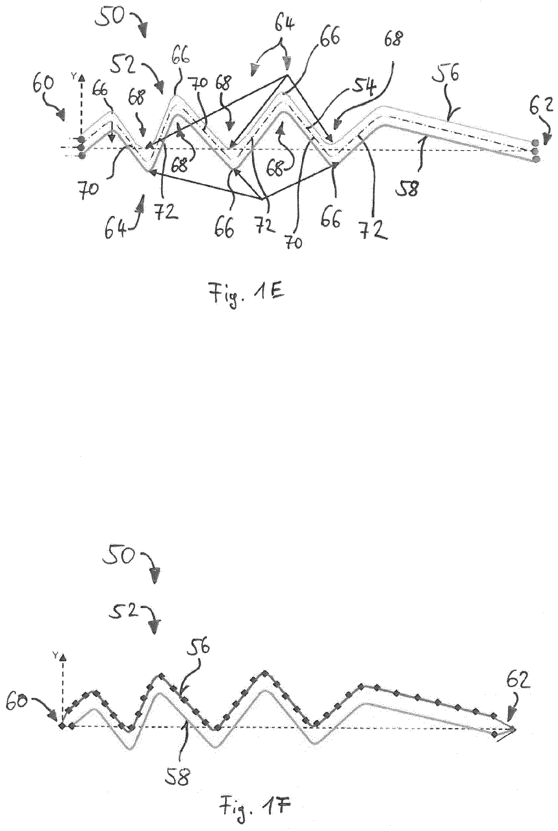

Referring to Fig. 1E, the derived airfoil 50 can also be generated by further processing the results of the previous step. In this case, the resulting modified contour 52 of the previous step defines a construction line 54. Based on the construction line 54, an upper derived airfoil surface 56 and a lower derived airfoil surface 58 are generated.

The upper derived airfoil surface 56 is constructed by shifting a copy of the construction line 54 upward along the thickness direction for an amount of about 2 % of the chord length. The lower derived airfoil surface 58 is constructed by shifting a copy of the construction line 54 downward along the thickness direction for an amount of about 2 % of the chord length. If desired or necessary, the fillet radii of the fillet portions 46 can be modified.

Referring to Fig. 1F, the upper and lower derived airfoil surfaces 56, 58 can be sampled/digitized and closed. The closing can be done by introducing a circle at the leading and trailing edge of the upper and lower derived airfoil surfaces 56, 58. The closed contour is stored as the airfoil manfacturing data.

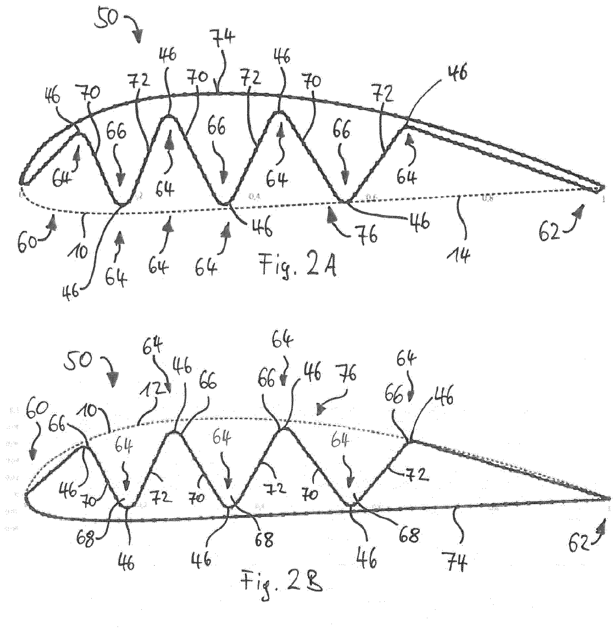

Referring to Fig. 2A another embodiment of a derived airfoil 50 is described in more detail. The template airfoil 10 is shown as a broken line for comparison. The derived airfoil 50 comprises a conventional surface portion 74 and a bionic surface portion 76. In this embodiment, the conventional surface portion 74 forms the upper derived airfoil surface 56 and the bionic surface portion 76 forms the lower derived airfoil surface 58. The bionic surface portion 76 is formed according to the modified contour 52. The bionic surface portion 76 includes a plurality of undulations 64, where recessed undulations 68 and protruding undulations 66 are alternating along the chordwise direction.

The recessed undulations 68 are formed to be recessed from the template airfoil 10, whereas the protruding undulations 66 protrude away from the conventional surface portion 74 along the thickness direction. The recessed undulations 68 form spaces that allow vortex formation by the airflow. The protruding undulations 66 end almost at the former template airfoil 10. The protruding undulations 66 separate the vortices that form in adjacent recessed undulations 68.

Referring to Fig. 2B another embodiment of a derived airfoil 50 is described in more detail. The template airfoil 10 is shown as a broken line for comparison. The derived airfoil 50 comprises a conventional surface portion 74 and a bionic surface portion 76. In this embodiment, the conventional surface portion 74 forms the lower derived airfoil surface 58 and the bionic surface portion 76 forms the upper derived airfoil surface 56. The bionic surface portion 76 is formed according to the modified contour 52. The bionic surface portion 76 includes a plurality of undulations 64, where recessed undulations 68 and protruding undulations 66 are alternating along the chordwise direction.

The recessed undulations 68 are formed to be recessed from the template airfoil 10, whereas the protruding undulations 66 protrude away from the conventional surface portion 74 along the thickness direction. The recessed undulations 68 form spaces that allow vortex formation by the airflow. The protruding undulations 66 end almost at the former template airfoil 10. The protruding undulations 66 separate the vortices that form in adjacent recessed undulations 68.

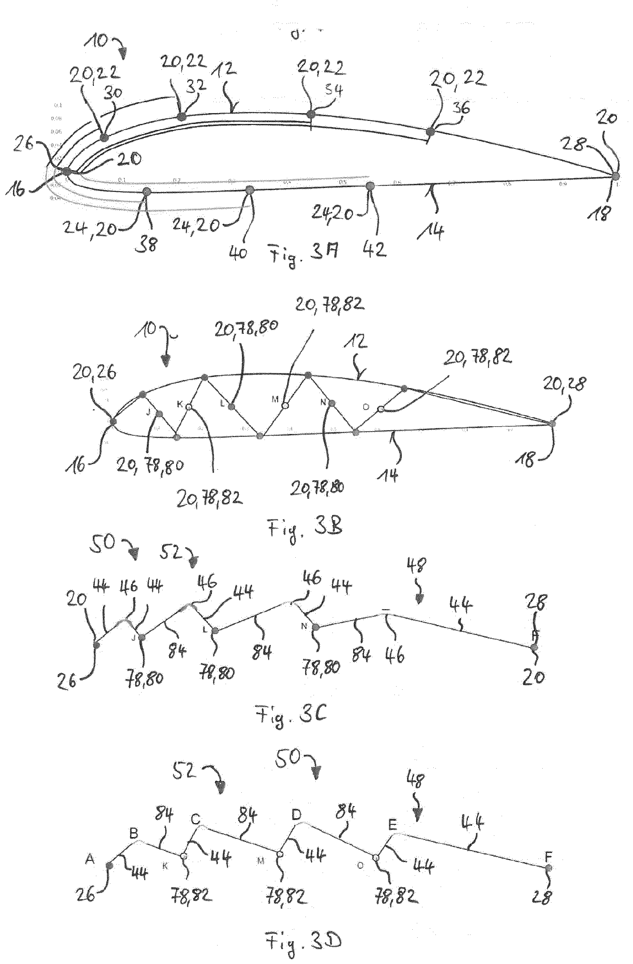

Referring to Fig. 3A to Fig. 3D a variant of the previously described method is described in more detail.

As indicated in Fig. 3A, the support points 20 are marked basically the same as previously.

As illustrated in Fig. 3B, a plurality of mid support points 78 are marked on the connecting line segments 44, such that preferably one mid support point 78 is on one connecting line segment 44. First mid support points 80 are marked on those connecting line segments 44 that are tilted towards the leading edge support point 26 and second mid support points 82 are marked on those connected line segments 44 that are tilted towards the trailing edge support point 28.

As illustrated in Fig. 3C, the modified contour 52 is achieved by removing those connecting line segments 44 that connect the first mid support points 80 with the lower support points 24. Furthermore, those connecting line segments 44 that include the second mid support points 82 are removed. Next, connecting line segments 84 are constructed that connect each first mid support point 80 with the closest upper support point 22. The region around the upper support points 22 is replaced with a fillet portion 46. It is also possible to do this with the region around the first mid support points 80. This results in a new modified contour 52 that may serve as a derived airfoil surface 48 or a construction line 54.

As illustrated in Fig. 3D, the modified contour 52 is achieved by removing those connecting line segments 44 that connect the second mid support points 82 with the lower support points 24. Furthermore, those connecting line segments 44 that include the first mid support points 80 are removed. Next, connecting line segments 84 are constructed that connect each second mid support point 82 with the closest upper support point 22. The region around the upper support points 22 is replaced with a fillet portion 46. It is also possible to do this with the region around the second mid support points 82. This results in a new modified contour 52 that may serve as a derived airfoil surface 48 or a construction line 54.

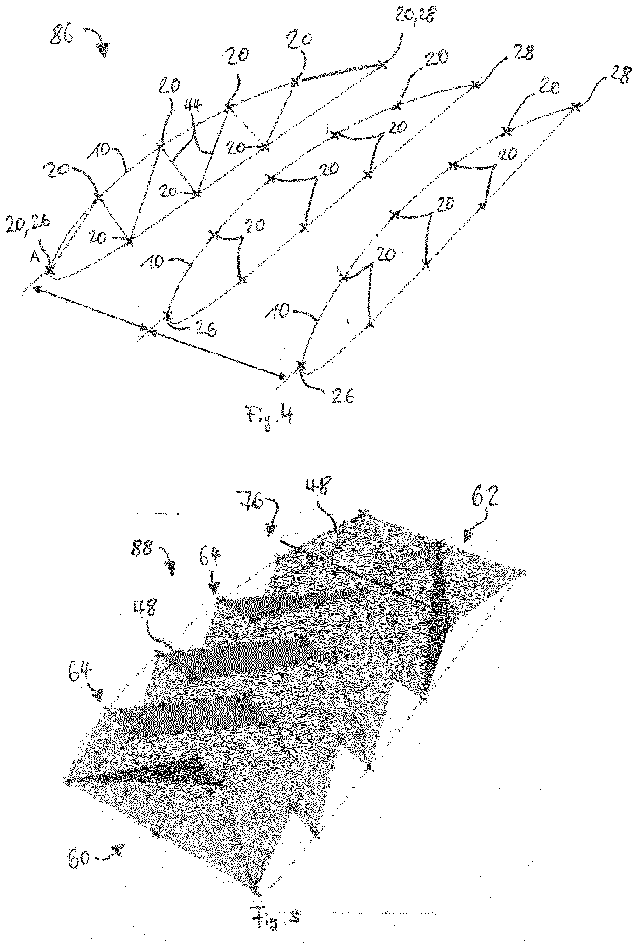

Referring to Fig. 4, the previously described method can be extened to a template wing 86. The template wing 86 comprises a plurality of template airfoils 10 that are spaced apart along the spanwise direction. The airfoils 10 may but to not have to correspond to ribs of the wing 86. While the template wing 86 is illustrated with identical template airfoils 10 it is possible for the template airfoils 10 to vary along the spanwise direction, in particular the chord length and/or camber may vary.

The support points 20 are marked similarly as before. It is also possible to start with the template airfoil 10, mark the support points 20, copy the template airfoil 10 and shift the marked template airfoil 10 along the spanwise direction.

Subseuqently, connecting line segments 44 are generated in the plane of the template airfoil 10 and between adjacent template airfoils 10. The connecting line segments 44 are generated without intersections and in a zig-zag pattern along the chordwise and spanwise directions, respectively. Similarly to before, fillet portions 46 may be formed.

Referring to Fig. 5, an embodiment of a derived airfoil surface 48 is illustrated. Undulations 64 are formed that undulate in the thickness direction along the chordwise direction and in the chordwise direction along the spanwise direction. In other word, the undulations 64 alternatingly form protruding undulations 66 and recessed undulations 68 along the chordwise direction, and each protruding undulation 66 and each recessed undulation 68 undulates in the chordwise direction when moving along the spanwise direction.

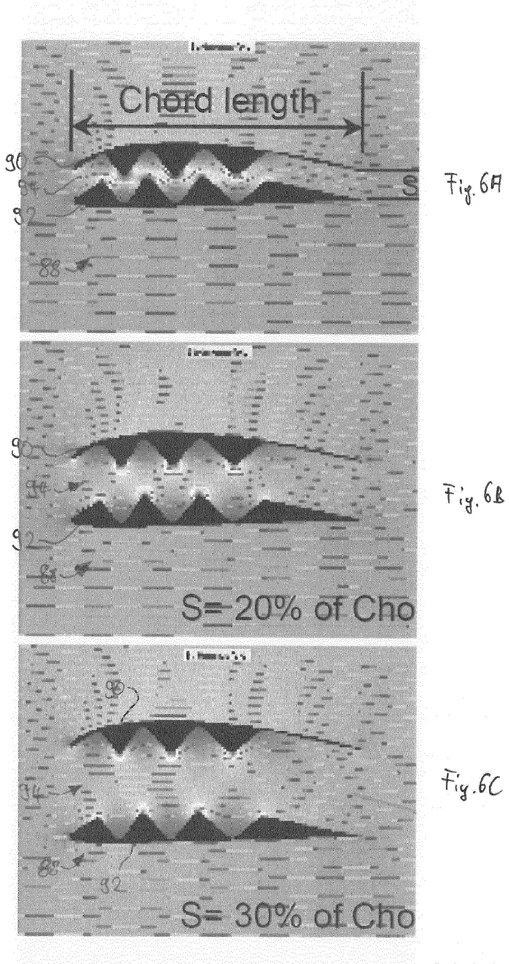

Referring to Fig. 6A to Fig. 6C, an embodiment of a derived wing 88 is illustrated. The derived wing 88 comprises a first derived airfoil 90 and a second derived airfoil 92.

The first derived airfoil 90 comprises a conventional surface portion 74 that forms an upper derived airfoil surface 56 and a bionic surface portion 76 that forms a lower derived airfoil surface 58. The first derived airfoil 90 is substantially indentical to the derived airfoil 50 of Fig. 2A. For sake of brevity, reference is made to the associated description for further details.

The second derived airfoil 92 comprises the conventional surface portion 74 that forms the lower derived airfoil surface 58 and the bionic surface portion 76 forms the upper derived airfoil surface 56. The second derived airfoil 92 is substantially indentical to the derived airfoil 50 of Fig. 3B. For sake of brevity, reference is made to the associated description for further details.

The derived wing 88 further comprises a mechanism (not shown) that allows a movement of the first and second derived airfoils 90, 92 relative to each other along the thickness direction. A possible mechanism is a scissor linkage or articulated linkage.

As illustrated, the first and second derived airfoils 90, 92 define a flow passage 94 therebetween. Fig. 6A to Fig. 6C depicts a progression of increasing size of the flow passage 94 from about 10 % to 30 % of the chord length measured along the thickness direction. The airflow around the derived wing 88 is indicated.

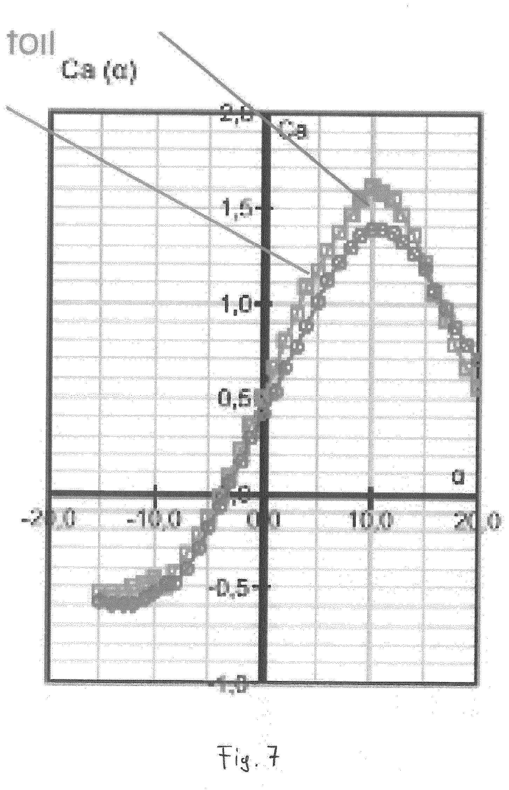

Fig. 7 illustrates a diagram of the lift coefficient (CI) dependence on the angle of attack (AoA). The line with circles indicates the Cl of the template airfoil 10, whereas the line with squares indicates the Cl of the derived wing 88 at 30 % split between the first and second derived airfoils 90, 92. As indicated in the diagram, the Cl increases by 0.2 at an AoA of 10°. While the coefficient of drag (Cd) is about 0.08 and thus larger as with conventional airfoils, it should be noted that this combination of Cl and Cd is suitable for so called "perching", where an aerial vehicle - similar to a bird - may land on a spot without stalling.

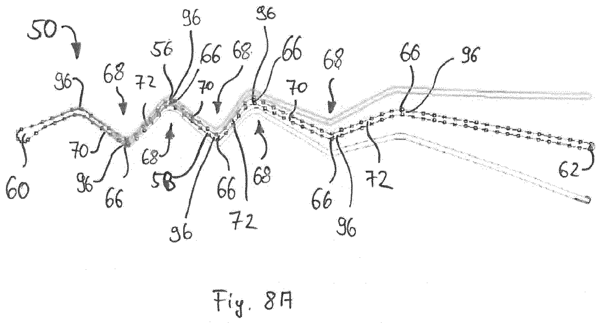

Referring to Fig. 8A, an embodiment of a derived airfoil 50 is described in more detail. The derived airfoil 50 can be obtained by the previously described method. The derived airfoil 50 comprises a derived leading edge portion 60 and a derived trailing edge portion 62. The derived leading edge portion 60 includes a leading edge section that is formed roughly in a drop-like cross-section, whereas the derived trailing edge portion has a trailing edge section that is formed roughly as a half circle.

The derived airfoil 50 comprises a plurality of undulations 64, that can be classfied into protruding undulations 66 and recessed undulations 68 which are formed in an alternating manner.

Each recessed undulation 68 forms a space for air to flow into and allows vortex formation. Each protruding undulation 66, in particular each fillet portion 46, separates two adjacent recessed undulations 68.

The each undulation 64 includes a first straight portion 70 and a second straight portion 72 that meet at the fillet portion 46.

As indicated in Fig. 8A, the fillet portions 46 allow a bending movement of the first and second straight portions 70, 72 relative to each other. The first and second straight portions 70, 72 can bend towards each other or away from each other, thereby also changing the size of the recessed undulation 68 and/or the cusp angle of the protruding undulation 66, respectively. The fillet portions 46 act as hinge portions 96.

The derived airfoil 50 can be self-adapting, i.e. bending up or bending down relative to the neutral position, to the current flow regime such that aerodynamic performance can be improved.

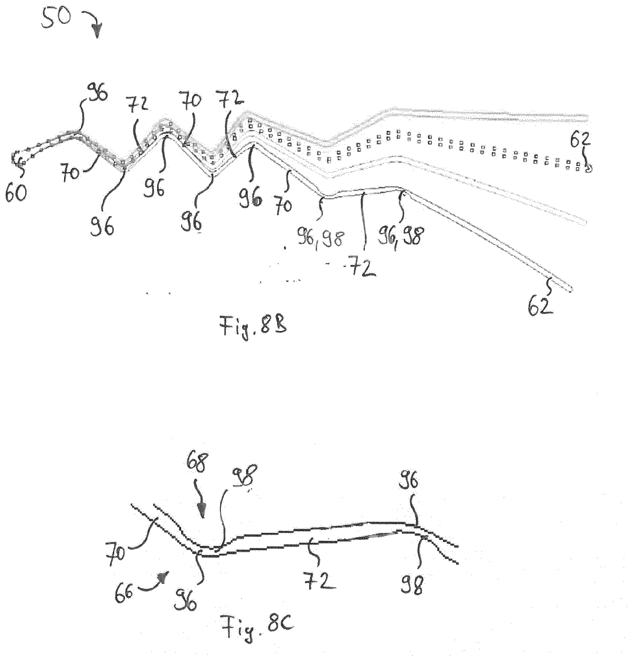

Referring to Fig. 8B and Fig. 8C, a variant of the derived airfoil 50 is described. The derived airfoil 50 comprises a plurality of hinge portions 96 that include an enfeeblement 98. The hinge portions 96 have a different bending threshold than the other fillet portions 46, i.e. the enfeebled hinge portions 96 have a different buckling force upon which the bending motion of the adjacent first and second straight portions 70, 72 towards or away from each other is allowed. As indicated in Fig. 8B, more positions of the self-adapting derived airfoil 50 can be defined with these features.

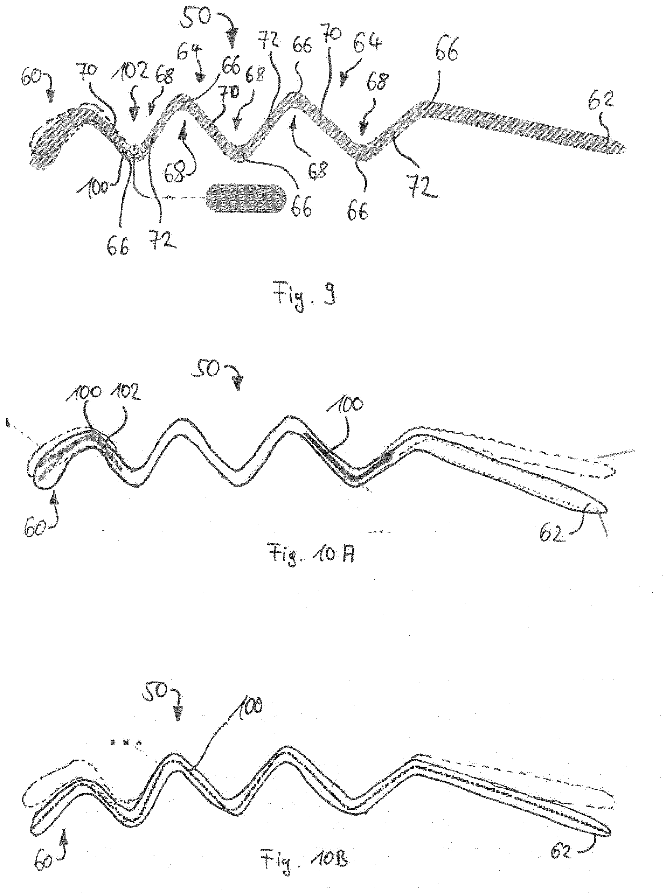

Referring to Fig. 9, an embodiment of an actively adaptable derived airfoil 50 is described. In contrast to the previous embodiments, which are passively adaptable, this embodiment comprises an actuator 100 that is configured as a leading edge actuator 102. The leading edge actuator 102 is disposed on a fillet portion 46. The leading edge actuator 102 may be of the fluid actuator type that includes a chamber that can be filled with pressurized fluid thereby moving the derived leading edge portion 60 downward. With this configuration a droop nose can be implemented for the derived airfoil 50.

Referring to Fig. 10A, an embodiment of a semi-actively adaptable derived airfoil 50 is described. The derived airfoil 50 includes a plurality of actuators 100, wherein one is configured as a leading edge actuator 102. The actuators 100 are formed by a shape-memory material (SMA) and a heating element, for example. When the heating element is energized the SMA is heated an goes back to its original shape. In this embodiment, the derived leading edge portion 60 is bent downwards like a droop nose. The derived trailing edge portion 62 is also bent downwards. Both effects combined change the camber of the drived airfoil 50. When the heating element is de-energizes, the aerodynamic forces can bend the portions of the derived airfoil 50 to adapt.

Referring to Fig. 10B, a variant of the derived airfoil 50 is illustrated with a single actuator 100. The actuator extends along the chordwise and spanwise directions to adapt the camber of the derived airfoil 50. Again the actuator 100 can be made of SMA and a corresponding heating element.

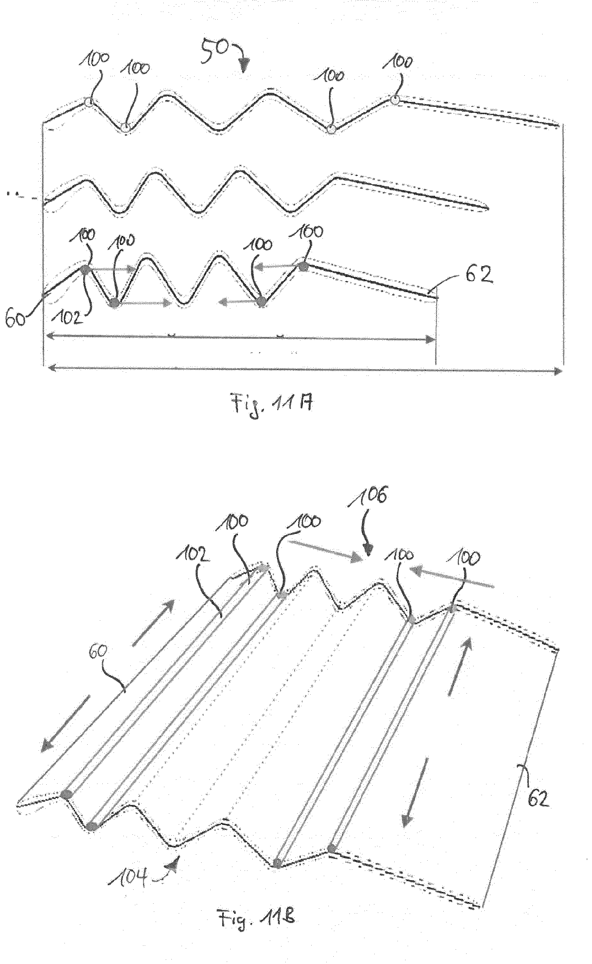

Referring to Fig. 11A, another embodiment of a derived airfoil 50 is illustrated. The derived airfoil 50 comprises a plurality of actuators 100 including a leading edge actuator 102. The actuators 100 can be of the fluid type. The actuators 100 can also be piezo actuators or electroactive polymers.

As illustrated in Fig. 11A from bottom to top, the chord length can be varied by activating the actuators 100 accordingly.

Fig. 11A, bottom: The actuators 100 may generate a force on the first and second straight portions 70, 72 so that they bend towards each other around the hinge portion 96. Thus, the chord length can be shoretened.

Fig. 11A, middle: The actuators 100 do not generate a force so the derived airfoil 50 is neutral. The derived airfoil 50 has its neutral chord length.

Fig. 11A, top: The actuators 100 generate a force on the first and second straight portions 70, 72 so that they bend away from each other around the hinge portion 96. Thus, the chord length can be extended.

Referring to Fig. 11B, a derived wing 88 based on a derived airfoil 50 is illustrated. Similar to the previous embodiment, a plurality of actuators 100 are formed. The actuators 100 are configured such that the force generated by them varies along the spanwise direction. For example, it is possible to extend the chord length of a first spanwise end 104, whereas the chord length of a second spanwise end 106 is shortened. This can be achieved, for example, by dividing the actuator 100 along the spanwise direction into different sections. Another possibility is to manufacture the actuator 100 with a certain characteristic along the spanwise direction.

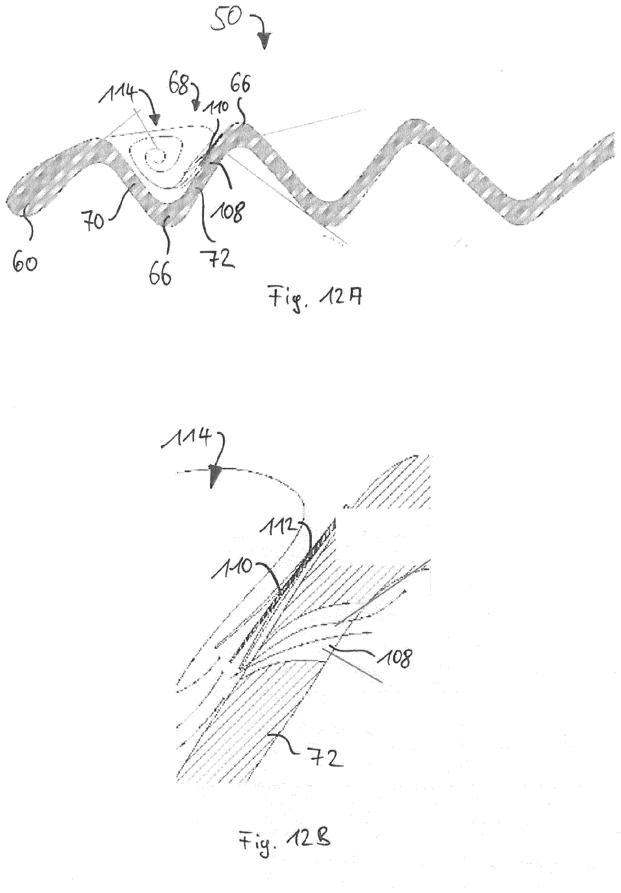

Referring to Fig. 12A and Fig. 12B, another embodiment of the derived airfoil 50 is described. The derived airfoil 50 comprises at least one fluid passage 108 that is formed to connect two undulations 64, specifically two recessed undulations 68. The fluid passage 108 is preferably formed as a hole in any of the first or second straight portions 70, 72. Multiple fluid passages 108 may be formed along the spanwise direction. The fluid passage 108 is at least partially covered by a leaf-like member 110. The leaf-like member 110 is able to control the amount of airflow through the fluid passage 108 depending on the amount of coverage. The leaf-like member 110 may be vibrated. The vibration can be generated actively by a piezo-actuator 112. The piezo-actuator 112 may form the leaf-like member 110 or be a separate member.

As depicted in Fig. 12A, an airflow generates a vortex 114 within the recessed undulation 64. The vortex 114 may serve to store mechanical energy of the airflow. In a low speed environment, the leaf-like member 110 is vibrated to introduce further mechanical energy into the vortex 114 that comes partially from another vortex connected via the fluid passage 108. With this configuration, the risk of stalling, i.e., detaching of the airflow from the derived airfoil 50, can be significantly reduced, espectially in low speed Reynolds regimes.

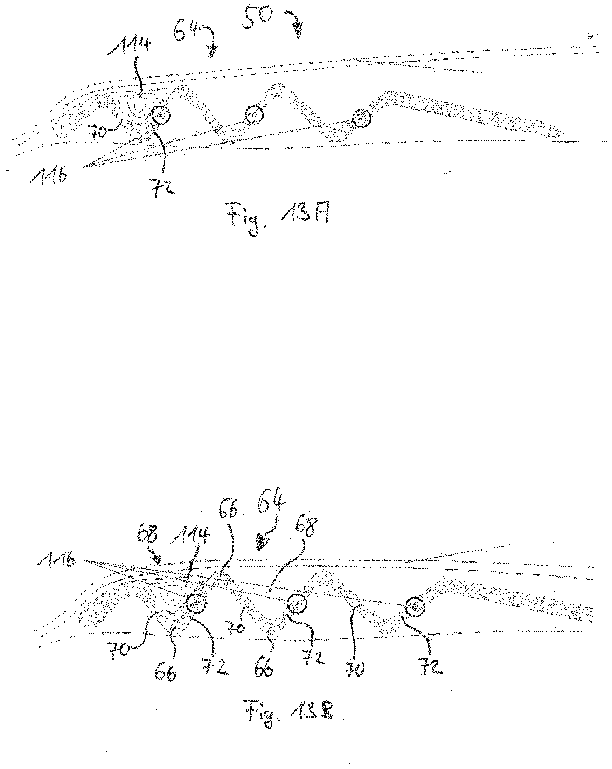

Referring to Fig. 13A and Fig. 13B another variant of the derived airfoil 50 is illustrated. The derived airfoil 50 comprises a plurality of rollers 116 that are arranged on the second straight portions 72. Each roller 116 is in contact with the vortex 114 formed in the respective recessed undulation 68.

As illustrated in Fig. 13A, the vortex 114 is formed, and the airflow is so slow that it detaches from the derived airfoil 50.

In Fig. 13B, the rollers 114 are activated and rotate. The rotation of the rollers 116 transfers momentum to the adjacent vortex 114. The vortex 114 increases in strength, which allows the airflow to reattach to the derived airfoil 50. As a result, the risk of stalling in low speed conditions can be significantly reduced.

In order to generate a bionic derived airfoil (50) from a conventional template airfoil (10), the invention proposes marking a plurality of upper support points (22) and lower support points (24) that are arranged on an upper template surface (12) and on the lower template surface (14) of the template airfoil (10), respectively. A plurality of connecting line segments (44, 84) is constructed between the upper support points (22) and the lower support points (24) in a manner that none of the connecting line segments (44, 84) intersect with each other. The resulting zig-zag pattern can be used as an aerodynamic surface of the bionic derived airfoil (50) or as a basis for a construction line (54) from which the bionic derived airfoil (50) is further generated. The resulting airfoil manufacturing data are given to an appropriate manufacturing facility for manufacture of the bionic derived airfoil (50).

### List of reference signs:

- 10: template airfoil
- 12: upper template surface
- 14: lower template surface
- 16: template leading edge
- 18: template trailing edge
- 20: support point
- 22: upper support point
- 24: lower support point
- 26: leading edge support point
- 28: trailing edge support point
- 30: first upper support point
- 32: second upper support point
- 34: third upper support point
- 36: fourth upper support point
- 38: first lower support point
- 40: second lower support point
- 42: third lower support point
- 44: connecting line segment
- 46: fillet portion
- 48: derived airfoil surface
- 50: derived airfoil
- 52: modified contour
- 54: construction line
- 56: upper derived airfoil surface
- 58: lower derived airfoil surface
- 60: derived leading edge portion
- 62: derived trailing edge portion
- 64: undulation
- 66: protruding undulation
- 68: recessed undulation
- 70: first straight portion
- 72: second straight portion
- 74: conventional surface portion
- 76: bionic surface portion
- 78: mid support point
- 80: first mid support point
- 82: second mid support point
- 84: connecting line segment
- 86: template wing
- 88: derived wing
- 90: first derived airfoil
- 92: second derived airfoil
- 94: flow passage
- 96: hinge portion
- 98: enfeeblement
- 100: actuator
- 102: leading edge actuator
- 104: first spanwise end
- 106: second spanwise end
- 108: fluid passage
- 110: leaf-like member
- 112: piezo-actuator
- 114: vortex
- 116: roller

## Claims

1. A computer-implemented method for generating airfoil manufacturing data from template data, wherein the airfoil manufacturing data are configured to cause manufacturing of a derived airfoil (50), wherein the template data describe a template airfoil (10), the method comprising:
a) marking a plurality of support points (20), namely at least upper support points (22) and lower support points (24), wherein the upper support points (22) are arranged on an upper template surface (12) of the template airfoil (10) and the lower support points (24) are arranged on a lower template surface (14) of the template airfoil (10);
b) constructing a plurality of connecting line segments (44, 84) between the upper support points (22) and the lower support points (24) in a manner that none of the connecting line segments (44, 84) intersect with each other;
c) generating the airfoil manufacturing data based on the results of step b).

2. The method of claim 1, wherein step a) involves marking the support points (20) including a leading edge support point (26), that is arranged where the upper template surface (12) and the lower template surface (14) meet at the leading edge location; and/or wherein step a) involves marking the support points (20) including a trailing edge support point (28), that is arranged where the upper template surface (12) and the lower template surface (14) meet at the trailing edge location.

3. The method claim 2, wherein step b) involves constructing a leading edge line segment that connects the leading edge support point (26) with the most forward upper support point (22) or lower support point (24); and/or wherein step b) involves constructing a trailing edge line segment that connects the trailing edge support point (28) with the most aftward upper support point (22) or lower support point (24).

4. The method of any of the preceding claims, wherein step a) involves marking the upper support points (22) and the lower support points (24) to be distributed along the chordwise direction such that connecting line segments (44, 84) that meet at a particular support point (20) form an acute angle or and obtuse angle.

5. The method of any of the preceding claims, wherein step a) involves marking the support points (20) including at least one mid support point (78), each mid support point (78) being arranged on one connecting line segment (44), preferably in the middle of the connecting line segment (44), and step c) involves modifying the connecting line segments (84) to meet at every other mid support point (78) along the chordwise direction and outputting the modified connecting line segments (44, 84) as the airfoil manufacturing data.

6. The method of any of the preceding claims, wherein step a) involves marking the support points (20) to be distributed along the chordwise and the spanwise direction of the template airfoil (10), and wherein step b) involves constructing the connecting line segments (44) also along the spanwise direction to form a zig-zag pattern, when viewed along the spanwise direction.

7. The method of any of the preceding claims, wherein step c) involves defining a construction line (54) that is composed of the connecting line segments (44, 84); and generating derived airfoil surface data, that describe a derived airfoil surface (48) of the derived airfoil (50), by generating surface line segments that are parallel to the construction line (54) and have a distance from the construction line (54) from 1 % to 5 % of the chord length, and outputting the surface line segments as airfoil manufacturing data.

8. The method of any of the preceding claims, wherein step c) involves:
for at least one support point (20), removing an end portion of the connecting line segments (44) meeting at the respective support point (20)and adding a fillet portion (46) that connects the remaining connecting line segments (44) to obtain a construction line (54), and outputting the construction line (54) as airfoil manufacturing data, wherein preferably the fillet radius of the fillet portion is 1 % to 10 % of the chord length.

9. The method of claim 8, wherein step c) involves defining the construction line (54) to include the fillet portion (46), and generating the derived airfoil surface data by generating a surface fillet portion that follows the contour of the construction line (54), and outputting the surface fillet portion as airfoil manufacturing data.

10. The method of any of the claims 8 or 9, wherein step c) involves generating upper derived airfoil surface data, that describe an upper derived airfoil surface (56), and generating lower derived airfoil surface data, that describe a lower derived airfoil surface (58), by setting an upper fillet radius of an upper fillet portion of the upper derived airfoil surface to be greater than a lower fillet radius of a lower fillet portion of the lower derived airfoil surface, and outputting the upper and lower derived airfoil surface data as the airfoil manufacturing data.

11. A manufacturing method for manufacturing a derived airfoil (50), the method comprising:
a) carrying out a method of any of the preceding claims to obtain airfoil manufacturing data;
b) manufacturing the derived airfoil (50) according to the airfoil manufacturing data.

12. An airfoil (50) for an aircraft, preferably a remotely piloted aerial vehicle, wherein the airfoil is obtainable by the method of claim 11; or
an aircraft, preferably a remotely piloted aerial vehicle, comprising an airfoil (50) obtainable by the method of claim 11.

13. A manufacturing facility comprising means for carrying out the method of claim 11.

14. A computer program comprising instructions that,
- upon execution by a computer, cause the computer to carry out a method of any of the claims 1 to 10; or
- upon execution by a manufacturing facility, cause the manufacturing facility to carry out the method of claim 11.

15. A computer-readable storage medium comprising the computer program of claim 14.
